# EUROPÄISCHE PATENTANMELDUNG

(11) **EP 4 703 744 A1**
(43) Veröffentlichungstag der Anmeldung: **04.03.2026**
(21) Anmeldenummer: 24197688.5
(22) Anmeldetag: 30.08.2024
(51) Int. Cl.: G01R 31/28, G01R 31/40, G01R 31/62

(54) **DETEKTIEREN ABNORMALER BETRIEBSBEDINGUNGEN VON ELEKTRISCHEN DROSSELN**

(71) Anmelder: Siemens Aktiengesellschaft, 80333 München (DE)
(72) Erfinder: Lange, Robert, 08451 Crimmitschau (DE)
(74) Vertreter: Siemens Patent Attorneys

(57) **Zusammenfassung**

Die Erfindung betrifft eine Detektierungsvorrichtung (1) zum Detektieren abnormaler Betriebsbedingungen an einer elektrischen Drosseleinheit (2), insbesondere einer stromkompensierenden Drosseleinheit (3) mit stromkompensierenden Drosseln, eines elektrischen Filters (4), aufweisend die elektrische Drosseleinheit (2) mit einer ersten elektrischen Drossel (5) im elektrischen Filter (4), verschaltet in einer ersten elektrischen Phase (6) eines elektrischen Wechselspannungsnetzes (7) oder einem internen Wechselspannungsnetz (8) eines elektrischen Umrichters (9), ein Spannungsbegrenzungselement (10) zur Spannungsbegrenzung von an der ersten elektrischen Drossel (5) auftretenden unerwünschten Spannungsabfällen, wobei das Spannungsbegrenzungselement (10) in einer Parallelschaltung zu der ersten elektrischen Drossel (5) angeordnet ist, und einen Temperatursensor (11), welcher an dem Spannungsbegrenzungselement (10) angeordnet ist. Weiterhin betrifft die Erfindung ein Detektierungsverfahren (27) zur Durchführung des Detektierens abnormaler Betriebsbedingungen an der elektrischen Drossel (2), insbesondere der stromkompensierenden Drossel (3), des elektrischen Filters (4) mittels der Detektierungsvorrichtung (1) und einen elektrischen Umrichter (9) mit der Detektierungsvorrichtung (1) welche zur Durchführung des Detektierungsverfahrens (27) ausgebildet ist.

## Beschreibung

Elektrische Filter gewinnen auch für den Betrieb von elektrischen Umrichtern im industriellen Umfeld - sowohl in der Antriebstechnik wie auch für die Energieerzeugung bzw. den Energietransport - eine stetig wachsende Bedeutung.

Die Anwendungsgebiete derartiger elektrischer Filter sind vielfältig. Neben der Sicherstellung der EMV (Elektromagnetische Verträglichkeit) von in einem elektrischen Netz (Wechselspannungsnetz) betriebenen elektrischen bzw. elektronischen Geräte, erwachsen aus dem Einsatz von beispielsweise Frequenzumrichtern qualitative Anforderungen an die im Betrieb erzeugten elektrischen Größen wie Strom und Spannung für deren bestimmungsgemäßen Betrieb, wobei das elektrische Netz zum Teil erheblich belasten werden kann.

Hier sei das Erzeugen von unerwünschter Blindleistung aber auch das unerwünschte Auftreten von elektrischen Spitzenwerten von elektrischen Größen wie dem Strom bzw. die Spannung erwähnt, was einerseits die Auslegung von elektrischen Netzen mit Blick auf deren elektrische Verluste beeinflusst, andererseits aber auch die Betriebssicherheit der am elektrischen Netz betriebenen elektrischen bzw. elektronischen Geräte beinträchtigen werden kann.

Oftmals werden für den Betrieb von elektrischen Umrichtern elektrische Filtern in den elektrischen Phasen der elektrischen Netze implementiert, welche in deren elektrischen Phasen stromkompensierte Drosseln aufweisen. Diese stromkompensierenden Drosseln (CNC) - auch Gleichtaktdrossel genannt - filtern (kompensieren) als Filterinduktivitäten den Gleichtaktanteil des Stromes in den elektrischen Phasen des elektrischen Netzes heraus und reagieren somit auf Gegentaktstörungen, können jedoch den Gegentaktanteil des Stromes weiterhin fließen lassen.

Eine Kombination aus stromkompensierenden Drosseln und Kondensatoranordnungen von Filterkapazitäten an den elektrischen Phasen kann ferner auch störende elektrische Einflüsse von Gegentaktstörung kompensieren.

An den stromkompensierenden Drosseln können im Betrieb jedoch abnormale Betriebsbedingungen auftreten, welche in den Hauptinduktivität und oder den Streuinduktivitäten der stromkompensierenden Drossel gemeinsam mit parasitären Kapazitäten bzw. betriebsgemäß vorgesehenen Filterkapazitäten einen Schwingkreis bilden. Dieser Schwingkreis kann unter speziellen Betriebsbedingungen unerwünscht stark angeregt werden, was zu einer unzulässigen Erwärmung der entsprechenden stromkompensierenden Drossel führen kann.

So treten im Falle der genannten speziellen Betriebsbedingungen beispielsweise unerwünschte Spannungsabfälle an den stromkompensierenden Drosseln auf, welche zu der unzulässigen Erwärmung führen können. Diese Spannungsabfälle werden zum Beispiel hervorgerufen durch einen Defekt von einem oder mehreren Filterkondensatoren (soweit im Filter vorgesehen) oder durch das Auftreten von Isolationsfehlern am Motoranschluss (defektes Motorkabel) eines von dem elektrischen Umrichter an einem IT-Netz (IT aus dem französischen für Isolé Terre) betriebenen elektrischen Motors.

Zwar kann eine Überstromabschaltung in dem elektrischen Netz einen Schutz vor derartigen kritischen Zuständen bieten, jedoch erfolgt dann eine Abschaltung der entsprechenden elektrischen Geräte am Netz, so dass das elektrische Gerät in seinem bestimmungsgemäßen Einsatz behindert wird bzw. dessen zuverlässiger Einsatz nicht gewährleistet ist.

Grundsätzlich konnten bisher derartig unerwünschter Betriebsbedingungen ermittelt und im Weiteren begrenz werden, indem eine Strommessung an den stromkompensierenden Drosseln beispielsweise in den elektrischen Phasen eines Drehstromnetzes jeweils Überströme detektiert, welche im Grunde zu der unzulässigen Erwärmung führen, oder die unzulässige Erwärmung wird mittels eines Temperatursensors direkt an der stromkompensierenden Drossel detektiert.

Eingangsseitige Strommessungen - für die stromkompensierenden Drosseln - am elektrischen Umrichter sind im unteren Preissegment bzw. für geringe Leistungsklassen der elektrischen Umrichter im meist nicht vorhanden, da sie teuer sind und aufwendig zu implementieren.

Das Detektieren mittels des Temperatursensor funktioniert im Allgemeinen nur bei einem kontinuierlichen (langsamen) Temperaturanstieg zuverlässig, da oft hohe thermische Übergangswiderstände zwischen der stromkompensierenden Drossel und dem Trägerbauteil des Temperatursensors liegen. Die Anordnung des Temperatursensors direkt auf der stromkompensierenden Drossel hat fertigungstechnische Nachteile, was zu erheblichen Aufwänden und damit eher zu einer teuren Sonderlösung der stromkompensierenden Drossel führt.

Der Erfindung liegt die Aufgabe zugrunde, eine Detektierungvorrichtung und ein Detektierungverfahren zum Detektieren abnormaler Betriebsbedingungen an einer elektrischen Drossel, insbesondere einer stromkompensierenden Drossel, eines elektrischen Filters sowie einen elektrischen Umrichter mit dem elektrischen Filter vorzuschlagen, welche das Detektieren der abnormaler Betriebsbedingung an der elektrischen Drossel gegenüber dem Stand der Technik verbessert.

Die Aufgabe wird durch eine Detektierungvorrichtung mit den in Anspruch 1 angegebenen Merkmalen, ein Detektierungsverfahren mit den in Anspruch 11 angegebenen Merkmalen und einen elektrischen Umrichter gemäß den in Anspruch 13 angegebenen Merkmalen gelöst.

Für die Lösung der Aufgabe wird Detektierungsvorrichtung zum Detektieren abnormaler Betriebsbedingungen an einer elektrischen Drosseleinheit, insbesondere einer stromkompensierenden Drosseleinheit mit stromkompensierenden Drosseln, eines elektrischen Filters vorgeschlagen, welche die elektrische Drosseleinheit mit einer ersten elektrischen Drossel im elektrischen Filters, verschaltet in einer ersten elektrischen Phase eines elektrischen Wechselspannungsnetzes oder einem internen Wechselspannungsnetz eines elektrischen Umrichters aufweist,- ein Spannungsbegrenzungselement zur Spannungsbegrenzung von an der ersten elektrischen Drossel auftretenden unerwünschten Spannungsabfällen aufweist, wobei das Spannungsbegrenzungselement in einer Parallelschaltung zu der ersten elektrischen Drossel angeordnet ist, und einen Temperatursensor aufweist, welcher an dem Spannungsbegrenzungselement angeordnet ist.

In vorteilhafter Weise werden durch das Spannungsbegrenzungselement die unerwünschten Spannungsabfälle, welche sich durch unerwünschte Schwingkeise bilden können, zumindest gedämpft, also begrenzt.

Gleichzeitig erwärmt sich das Spannungsbegrenzungselement, so dass mittels des Temperatursensors eine Aussage über die für die erste elektrische Drossel zulässige Temperatur getroffen werden kann. Damit ist ein kostengünstiges, zuverlässiges Detektieren von abnormaler Betriebsbedingungen an der elektrischen Drosseleinheit durchführbar.

Vorteilhafte Ausgestaltungsformen der Detektierungvorrichtung sind in den abhängigen Ansprüchen angegeben.

Bei einer ersten vorteilhaften Ausgestaltungsform der Detektierungvorrichtung ist das Spannungsbegrenzungselement ein elektrisches Gasableiterelement.

Ein elektrische Gasableiterelement ist eine Gasentladungsröhre, die als Überspannungsableiter insbesondere beim Schutz vor Überspannungsimpulsen vorteilhaft eingesetzt werden können, wobei diese bisher eher für den Schutz bei Blitzeinschlägen in elektrische Netze, wie auch Telefonnetze eingesetzt werden.

Bei einer weiteren vorteilhaften Ausgestaltungsform der Detektierungvorrichtung ist das Spannungsbegrenzungselement ein Varistor.

Varistoren können in vorteilhafter Weise Spannungsabfälle über elektrischen Bauelementen begrenzen, um diese elektrischen Bauelemente vor einer Überspannung und damit vor einer Zerstörung zu schützen.

Bei einer weiteren vorteilhaften Ausgestaltungsform der Detektierungvorrichtung ist das Spannungsbegrenzungselement eine TVS-Diode (Transient Voltage Suppressor Diode).

Auch TVS-Dioden werden allgemein zum Schutz vor elektrischen Überlastungen verwendet, wie es so bei einem Blitzeinschlag und ebenso beim Schalten induktiver Lasten und bei elektrostatischer Entladung zu Überspannungen kommen kann.

Bei einer weiteren vorteilhaften Ausgestaltungsform der Detektierungvorrichtung ist das Spannungsbegrenzungselement ein elektrischer Widerstand.

Der elektrische Widerstand ist ebenfalls ein - sehr kostengünstiges - Mittel, um Energie, welche sich aus einer Überspannung rekrutiert, in Wärme umzusetzen und somit hier Drosseln vor einer Zerstörung zu schützen und gleichzeitig als ein Mittel des Detektierens von abnormalen Betriebszuständen zum Einsatz zu kommen.

Bei einer weiteren vorteilhaften Ausgestaltungsform der Detektierungvorrichtung sind das Spannungsbegrenzungselement und der Temperatursensor auf einem Trägerelement angeordnet.

Die enge Anordnung auf einem Trägerelement ermöglich in vorteilhafter Weise eine sehr genaue Temperaturerfassung der Temperatur des Spannungsbegrenzungselements.

Bei einer weiteren vorteilhaften Ausgestaltungsform der Detektierungvorrichtung sind das Spannungsbegrenzungselement und der Temperatursensor jeweils auf gegenüberliegenden Seiten des Trägerelementes überlappend angeordnet.

Die überlappende Anordnung des Spannungsbegrenzungselements und des Temperatursensors verbessert die Qualität der Temperaturerfassung weiter.

Bei einer weiteren vorteilhaften Ausgestaltungsform der Detektierungvorrichtung stellt eine thermische Durchkontaktierung am Trägerelement eine thermische Verbindung zwischen dem Spannungsbegrenzungselement und der Temperatursensor her.

Eine Durchkontaktierung am Trägerelement zur Herstellung einer nochmals besseren thermischen Verbindung zwischen dem Spannungsbegrenzungselement und der Temperatursensor stellt ein Optimum des thermischen Übergangs von dem Spannungsbegrenzungselement und dem Temperatursensor für die Temperaturerfassung dar.

Bei einer weiteren vorteilhaften Ausgestaltungsform der Detektierungvorrichtung weisen die Spannungsabfälle und die damit einhergehenden Stromspitzen eines Stromverlaufs in der ersten elektrischen Phase des elektrischen Wechselspannungsnetzes oder des internen Wechselspannungsnetzes des elektrischen Umrichters durch die erste elektrische Drossel einen Frequenzverlauf mit einer Impulsdauer von <= 10 µs auf.

Die genannten Impulsdauer von <= 10 µs ermöglicht in vorteilhafter Weise ein Beherrschung von Prozessen bei hochdynamischen Frequenzverläufen von Spannungsabfällen und den daraus resultierenden Stromverläufen von insbesondere stromkompensierenden Drosseln im Einsatz bei elektrischen Filtern von elektrischen Umrichtern.

Bei einer weiteren vorteilhaften Ausgestaltungsform der Detektierungvorrichtung sind in einem mindestens dreiphasigen Netz in einer ersten weiteren elektrischen Phase und einer zweiten weiteren elektrischen Phase des elektrischen Wechselspannungsnetzes oder des internen Wechselspannungsnetzes des elektrischen Umrichters eine erste weitere elektrische Drossel und eine zweite weitere elektrische Drossel angeordnet, welche mit der ersten elektrischen Drossel von einem gemeinsamen Drosselkern umgeben sind.

Für die Lösung der Aufgabe wird weiterhin ein Detektierungsverfahren zum Detektieren abnormaler Betriebsbedingungen an einer elektrischen Drossel, insbesondere einer stromkompensierenden Drossel, eines elektrischen Filters für die erfindungsgemäße Detektierungsvorrichtung vorgeschlagen, wobei das Spannungsbegrenzungselement die unerwünschten Spannungsabfälle an der ersten elektrischen Drossel der Drosseleinheit, und/oder an, wenn vorhanden, den weiteren elektrischen Drosseln der Drosseleinheit, begrenzt und der Temperatursensor eine Temperatur des Spannungsbegrenzungselements erfasst und für eine Auswertung der Temperatur an eine Auswertungseinheit weiterleitet.

Bei einer ersten vorteilhaften Ausgestaltungsform des Detektierungsverfahrens erfolgt in Auswertung der Temperatur der Auswerteeinheit im Falle eines unzulässig hohen Temperaturwerts der Temperatur eine Abschaltung der ersten elektrischen Drossel und, wenn vorhanden, der weiteren elektrischen Drosseln der Drosseleinheit.

Für die Lösung der Aufgabe wird ferner ein elektrischer Umrichter mit der Detektierungsvorrichtung zum Detektieren abnormaler Betriebsbedingungen an der elektrischen Drosseleinheit, insbesondere der stromkompensierenden Drosseleinheit mit stromkompensierenden Drosseln, des elektrischen Filters vorgeschlagen, wobei die Detektierungsvorrichtung zur Durchführung des Detektierungsverfahrens ausgebildet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: ein schematisches Diagramm mit Stromspitzen eines Stromverlaufs, welcher durch unerwünschte Spannungsabfälle einer ersten elektrischen Drossel einer elektrischen Drosseleinheit in einem elektrischen Filter auftritt,
- FIG 2: eine erste schematische Darstellung der erfindungsgemäßen Detektierungsvorrichtung und dem erfindungsgemäßen Detektierungsverfahren in einem elektrischen Umrichter und
- FIG 3: eine zweite schematische Darstellung der erfindungsgemäßen Detektierungsvorrichtung gemäß FIG 2.

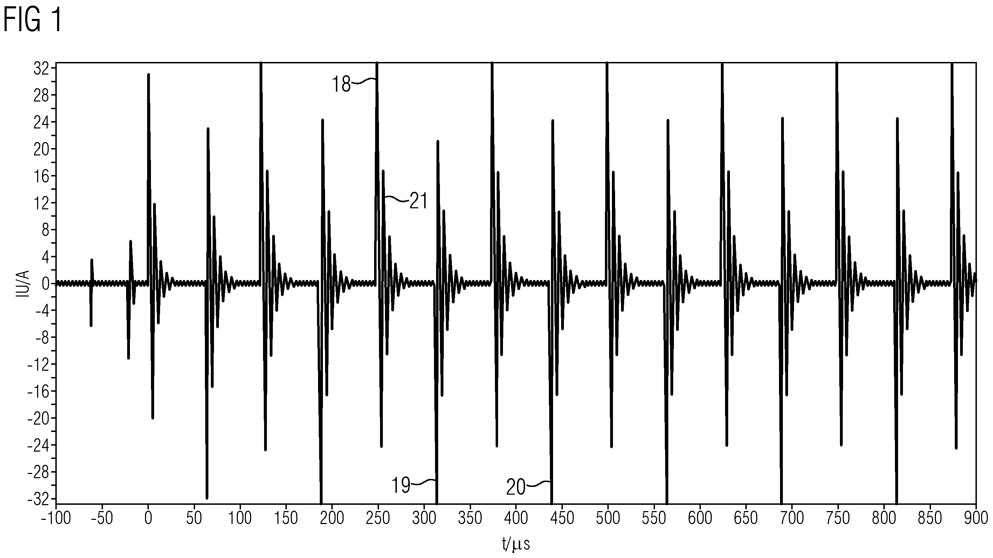

Die FIG 1 zeigt ein schematisches Diagramm mit einem typischen Stromspitzen 18 eines Stromverlauf 19, welcher aufgrund von unerwünschten Spannungsabfällen in einer ersten elektrischen Drossel 5 einer elektrische Drosseleinheit 2 in einem elektrischen Filter 4 auftritt.

Der Stromverlauf 19 ist gekennzeichnet durch die hohen Spannungsabfälle über der beispielhaft ersten elektrischen Drossel 5 der elektrischen Drosseleinheit 2 des Filters, welche periodisch verlaufen bei einem gezeigten Frequenzverlauf 20 mit einer Impulsdauer21 von hier kleiner 10µs.

Dieser Stromverlauf 19 mit Stromspitzen von bis zu 32A erzeugt eine unerwünscht hohe Erwärmung der ersten elektrischen Drossel 5, was zu vermeiden ist, um diese nicht zu zerstören.

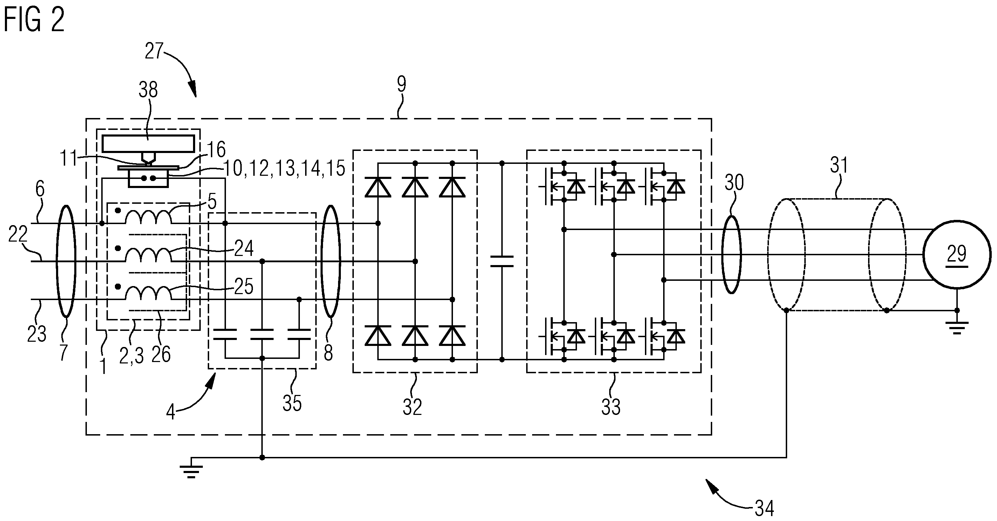

Mit FIG 2 wird eine erste schematische Darstellung der erfindungsgemäßen Detektierungsvorrichtung 1 und dem erfindungsgemäßen Detektierungsverfahren 27 in einem elektrischen Umrichter 9 gezeigt.

Der elektrische Umrichter 9 wird eingangsseitig an einem elektrischen Wechselspannungsnetzes 7 betrieben und treibt einen elektrischen Motor 29, welcher ausgangsseitig des elektrischen Umrichters 9 mit einem weiteren Wechselspannungsnetz 30 verbunden ist.

Das weitere Wechselspannungsnetz hat eine geschirmte Leitung 31 und der elektrische Umrichter 9 und der elektrische Motor werden an einem IT-Netz 34 betrieben.

Der elektrische Umrichter 9 ist mit einem Diodengleichrichter 32 und einem Wechselrichter 33 mit schaltbaren Leistungshalbleitern ausgebildet.

Zum Filtern der Eingangsströme und Eingangsspannungen des elektrischen Umrichters 9 kommt ein elektrischer Filter 4 zum Einsatz, welcher hier eine Drosseleinheit 2, ausgebildet als stromkompensierende Drosseleinheit 3 in Kombination eine Kondensatoreinheit 35 aufweist, eingangsseitig verbunden mit dem elektrischen Wechselspannungsnetzes 7 und ausgangsseitig verbunden mit einem internen Wechselspannungsnetz 8 des elektrischen Umrichters 9.

Die Wechselspannungsnetze am bzw. im Umrichter sind dreiphasig ausgelegt, so dass das elektrischen Wechselspannungsnetzes 7 eine erste elektrische Phase 6 mit einer ersten elektrischen Drossel 5, eine weitere erste elektrische Phase 22 mit einer weiteren ersten elektrischen Drossel 24 und eine weitere elektrische Phase 23 mit einer zweiten weiteren elektrischen Drossel 25 aufweist, alle Drosseln 5,24,25 umgeben von einem Drosselkern 26.

Mittels der Detektierungsvorrichtung 1 ist das Spannungsbegrenzungselement 10 parallel zu der ersten elektrischen Drossel 5 verschaltet und kann unerwünschte Spannungsabfälle über der ersten elektrischen Drossel 5 in Wärme überführen. Die der Temperatursensor 11 erfasst die Temperatur an dem Spannungsbegrenzungselement 10, so dass eine Aussage über die an der ersten elektrischen Drossel 5 maximal möglichen Temperatur mittels der Auswerteeinheit 28 erfolgt. Das Detektierungsverfahren 27 überprüft diese Temperatur und leitet bei Überschreitung der zulässigen Temperatur die Abschaltung aller Drosseln 5,24,26 ein.

Sowohl das Spannungsbegrenzungselement 10 wie auch der Temperatursensor 11 sind auf einem Trägerelement 16 jeweils auf einer Seite des Trägerelements 16 angeordnet.

Durch die Erfindung können somit abnormale Bedingungen insbesondere auch in stromkompensierten Drosseln detektiert werden. In Versuchen an Umrichtern konnten zuverlässig Auslösezeiten von <10s erreicht werden.

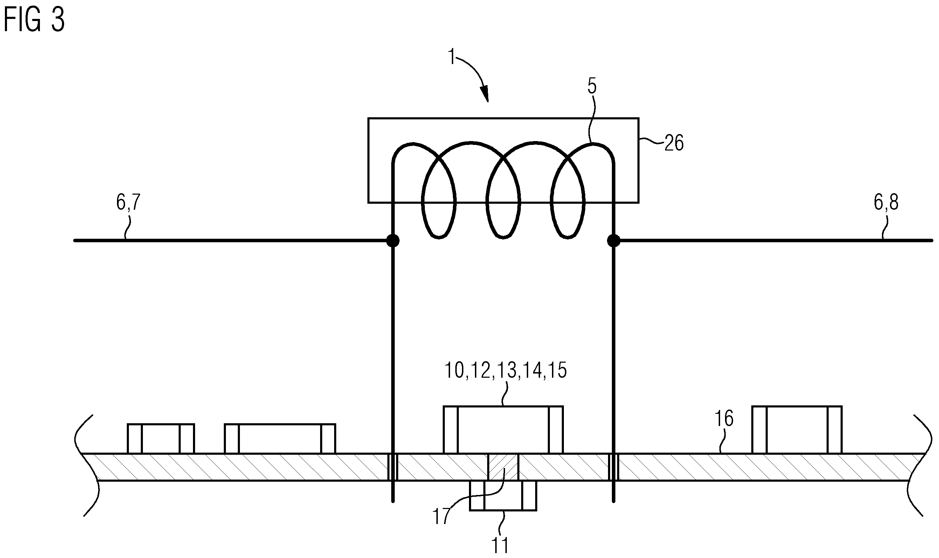

Die FIG 3 zeigt eine zweite schematische Darstellung der erfindungsgemäßen Detektierungsvorrichtung 1 im Detail anhand des Beispiels der ersten elektrischen Drossel 5. Diese erste elektrische Drossel 5 ist mit den weiteren elektrischen Drosseln (hier nicht gezeigt) von einem gemeinsamen Drosselkern 26 umgeben.

Die erste elektrische Drossel 5 ist eingangsseitig mit der ersten elektrischen Phase 6 des elektrischen Wechselspannungsnetzes 7 und weiter ausgangsseitig über die Weiterführung der ersten elektrischen Phase 6 mit dem internen Wechselspannungsnetz 8 des elektrischen Umrichters verbunden.

Parallel zur ersten elektrischen Drossel 5 ist das Spannungsbegrenzungselement 10 elektrisch verschaltet und getrennt durch die Trägerplatte 16, ist der Temperatursensor 11 mittels einer thermischen Durchkontaktierung 17 - welche durch das Trägerelement 16 führt - mit dem Spannungsbegrenzungselement 10 thermisch verbunden, so dass die Temperatur an dem Spannungsbegrenzungselement 10 vorteilhaft ermittelt werden kann.

## Patentansprüche

1. Detektierungsvorrichtung (1) zum Detektieren abnormaler Betriebsbedingungen an einer elektrischen Drosseleinheit (2), insbesondere einer stromkompensierenden Drosseleinheit (3) mit stromkompensierenden Drosseln, eines elektrischen Filters (4), aufweisend
- die elektrische Drosseleinheit (2) mit einer ersten elektrischen Drossel (5) im elektrischen Filter (4), verschaltet in einer ersten elektrischen Phase (6) eines elektrischen Wechselspannungsnetzes (7) oder einem internen Wechselspannungsnetz (8) eines elektrischen Umrichters (9),
- ein Spannungsbegrenzungselement (10) zur Spannungsbegrenzung von an der ersten elektrischen Drossel (5) auftretenden unerwünschten Spannungsabfällen, wobei das Spannungsbegrenzungselement (10) in einer Parallelschaltung zu der ersten elektrischen Drossel (5) angeordnet ist, und
- einen Temperatursensor (11), welcher an dem Spannungsbegrenzungselement (10) angeordnet ist.

2. Detektierungsvorrichtung (1) nach Anspruch 1, wobei das Spannungsbegrenzungselement (10) ein elektrisches Gasableiterelement (12) ist.

3. Detektierungsvorrichtung (1) nach Anspruch 1, wobei das Spannungsbegrenzungselement (10) ein Varistor (13) ist.

4. Detektierungsvorrichtung (1) nach Anspruch 1, wobei das Spannungsbegrenzungselement (10) eine TVS-Diode (14) ist.

5. Detektierungsvorrichtung (1) nach Anspruch 1, wobei das Spannungsbegrenzungselement (10) ein elektrischer Widerstand (15) ist.

6. Detektierungsvorrichtung (1) nach einem der vorhergehenden Ansprüche, wobei das Spannungsbegrenzungselement (10) und der Temperatursensor (11) auf einem Trägerelement (16) angeordnet sind.

7. Detektierungsvorrichtung (1) nach Anspruch 6, wobei das Spannungsbegrenzungselement (10) und der Temperatursensor (11) jeweils auf gegenüberliegenden Seiten des Trägerelementes (16) überlappend angeordnet sind.

8. Detektierungsvorrichtung (1) nach Anspruch 7, wobei eine thermische Durchkontaktierung (17) am Trägerelement (16) eine thermische Verbindung zwischen dem Spannungsbegrenzungselement (10) und der Temperatursensor (11) herstellt.

9. Detektierungsvorrichtung (1) nach einem der vorherigen Ansprüche, wobei die Spannungsabfälle und die damit einhergehenden Stromspitzen (18) eines Stromverlaufs (19) in der ersten elektrischen Phase (6) des elektrischen Wechselspannungsnetzes (7) oder des internen Wechselspannungsnetzes (8) des elektrischen Umrichters (9) durch die erste elektrische Drossel (5) einen Frequenzverlauf (20) mit einer Impulsdauer (21) von <= 10 µs aufweisen.

10. Detektierungsvorrichtung (1) nach einem der vorherigen Ansprüche, wobei in einem mindestens dreiphasigen Netz in einer ersten weiteren elektrischen Phase (22) und einer zweiten weiteren elektrischen Phase (23) des elektrischen Wechselspannungsnetzes (7) oder des internen Wechselspannungsnetzes (8) des elektrischen Umrichters (9) eine erste weitere elektrische Drossel (24) und eine zweite weitere elektrische Drossel (25) angeordnet sind, welche mit der ersten elektrischen Drossel (5) von einem gemeinsamen Drosselkern (26) umgeben sind.

11. Detektierungsverfahren (27) zum Detektieren abnormaler Betriebsbedingungen an einer elektrischen Drossel (2), insbesondere einer stromkompensierenden Drossel (3), eines elektrischen Filters (4) für eine Detektierungsvorrichtung (1) nach einem der Ansprüche 1-9, wobei
- das Spannungsbegrenzungselement (10) die unerwünschten Spannungsabfälle an der ersten elektrischen Drossel (5) der Drosseleinheit (2), und/oder an, wenn vorhanden, den weiteren elektrischen Drosseln (24,25) der Drosseleinheit (2), begrenzt und
- der Temperatursensor (11) eine Temperatur des Spannungsbegrenzungselements (10) erfasst und für eine Auswertung der Temperatur an eine Auswertungseinheit (28) weiterleitet.

12. Detektierungsverfahren (27) nach Anspruch 11, wobei in Auswertung der Temperatur der Auswerteeinheit (28) im Falle eines unzulässig hohen Temperaturwerts der Temperatur eine Abschaltung der ersten elektrischen Drossel (5) und, wenn vorhanden, der weiteren elektrischen Drosseln (24,25) der Drosseleinheit (2) erfolgt.

13. Elektrischer Umrichter (9) mit der Detektierungsvorrichtung (1) zum Detektieren abnormaler Betriebsbedingungen an der elektrischen Drosseleinheit (2), insbesondere der stromkompensierenden Drosseleinheit (3) mit stromkompensierenden Drosseln, des elektrischen Filters (4) nach einem der Ansprüche 1-10, wobei die Detektierungsvorrichtung (1) zur Durchführung des Detektierungsverfahrens (27) nach einem der Ansprüche 11 und 12 ausgebildet ist.
